# EUROPEAN PATENT APPLICATION

(11) **EP 1 742 371 A1**
(43) Date of publication of application: **10.01.2007**
(21) Application number: 06253462.3
(22) Date of filing: 30.06.2006
(51) Int. Cl.: H03M 9/00, H04L 25/02

(54) **Input/output (I/O) interface for high-speed data converters**

(30) Priority: 01.07.2005 US 173134
(71) Applicant: Agilent Technologies, Inc., Palo Alto, CA 94306 (US)
(72) Inventor: Neff, Robert M.R., Loveland, CO 80537-0599 (US); Poulton, Kenneth D., Loveland, CO 80537-0599 (US); Setterberg, Brian D., Loveland, CO 80537-0599 (US); Wuppermann, Bernd, Loveland, CO 80537-0599 (US); Genther, Scott Allan, Loveland, CO 80537-0599 (US); Montijo, Allen, Loveland, CO 80537-0599 (US)
(74) Representative: Jehan, Robert

(57) **Abstract**

An input/output interface for high-speed data converters is shown, which includes a serializer (22a) that transforms the N parallel data bits (13a) provided by an ADC (12a) into multiple serial data signals (15a), each of the multiple serial data signals having a corresponding embedded clock.
The I/O interface also includes a deserializer (26a) that receives the multiple serial data signals (15a).
An encoder (30a) may be placed between the ADC (12a) and the serializer (22a) to provide DC balance within each serial signal or to scramble the ADC data so as to decorrelate noise generated by the ADC (12a).

## Description

The present invention relates to a system including de-serializer for extracting a clock from a plurality of serial data signals and in the preferred embodiment to an input/output (I/O) interface for high-speed data converters.

Input/output (I/O) interfaces couple data converters, such as analog-to-digital converters (ADCs) and digital-to-analog converters (DACs), to memories, digital signal processors, or other systems. I/O interfaces for high-speed data converters need sufficient data handling capacity to accommodate high data rates of digital signals that are associated with the high-speed data converters. For example, the I/O interface for an 8-bit ADC operating at a sample rate of 5 Giga-Samples per second (GSa/s) needs to accommodate a data rate of 40 Gbits/second (Gb/s).

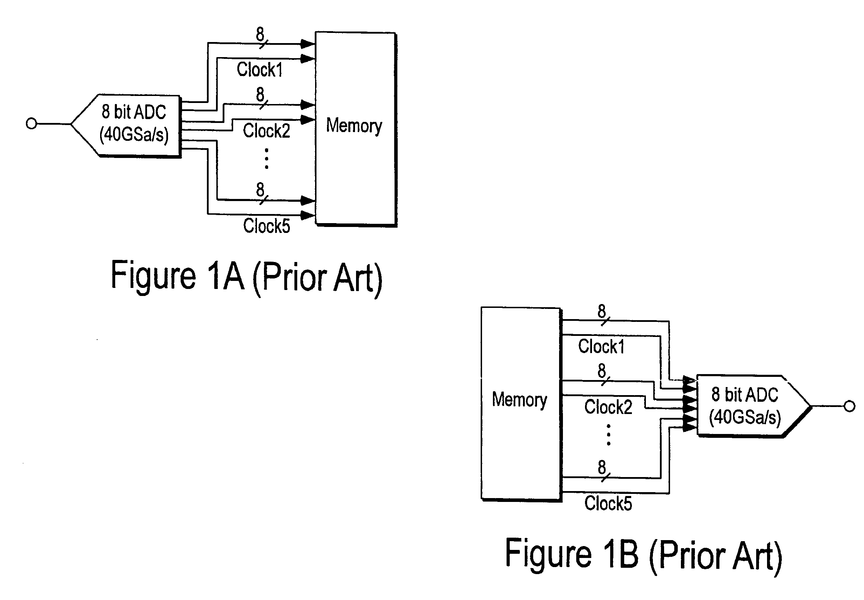

Parallel interfaces (shown in Figures 1A-1B) accommodate high data rates of high-speed data converters by using multiple groups of data lines in a parallel arrangement. Each group of data lines has a corresponding clock line that is separate from the group of data lines. The parallel interfaces rely on establishing and maintaining a precise timing relationship between each group of data lines and the corresponding clock line. The timing relationship is typically achieved by precisely controlling signal path lengths of the clock lines relative to the data lines, and by precisely controlling delays within drivers and receivers (not shown) in the parallel interfaces. However, defining and maintaining the timing relationship to within sufficient tolerances to accommodate high data rates can be difficult, especially when the clock and data lines are implemented on a printed circuit board, and can limit the data rates that can be attained for the parallel interfaces.

The parallel interface also has the disadvantage of including a high number of data lines. For example, to accommodate the data rate of 40Gb/s with data lines that have a data handling capacity of 1Gb/s, the parallel interfaces shown in Figures 1A-1B include 40 data lines (i.e. 5 groups of 8 data lines) and 5 clock lines. The high number of data lines and clock lines can occupy substantial physical space on a circuit board, and since each of the data lines has an associated driver, the high number of drivers typically causes the parallel interface to have high power consumption.

In a serial interface, such as that included in the ANALOG DEVICES, AD7872, data signals from one data converter are transmitted serially over a single data line. While this type of serial interface is more compact, and has lower power consumption and more relaxed timing requirements than a parallel interface, this type of serial interface may not have sufficient data handling capacity for high-speed data converters due to the limited data rate that can be achieved via the single data line. Accordingly, prior art serial interfaces are typically used in low-speed data converters that are included in voltmeters, system monitors, or in audio applications.

The present invention seeks to provide an improved input/output interface and improved system including a de-serializer.

According to an aspect of the present invention there is provided a system as specified in claim 1.

According to another aspect of the present invention there is provided a system as specified in claim 3.

According to another aspect of the present invention there is provided a system comprising a set of serializers coupled to a series of analog-to-digital (ADC) converters that acquire time-interleaved samples of an applied signal at a sample rate, the set of serializers receive a parallel data bits from the series of ADCs and transform the received parallel data bits into multiple serial data signals each having a corresponding embedded clock; a plurality of signal paths that each accommodate a corresponding one of the multiple serial data signals; and a de-serializer extracting a clock from each of the multiple serial data signals and constructing a data set based on serial data within each of the multiple serial data signals, wherein the data set represents the time-interleaved samples of the applied signal.

Embodiments of the present invention are described below, by way of example only, with reference to the accompanying drawings, in which:
Figures 1A-1B show prior art parallel interfaces; and
Figures 2A-2B and 3 show I/O interfaces according to various embodiments of the present invention.

Figures 2A-2B show an input/output (I/O) interface according to various embodiments of the present invention. Typically, the I/O interface provides coupling between a data converter, such as an analog-to-digital converter (ADC) 12a or a digital-to-analog converter (DAC) 12b, and a memory, data processor, or other system 14a, 14b. Figure 2A shows an example wherein an I/O interface 10 is distributed between an ADC integrated circuit 16a and a memory system 18a, and wherein the data converter is a high-speed N-bit ADC 12a that converts an applied analog signal 11a into samples that represent the analog signal 11a. The samples are typically provided at the output 20a of the ADC 12a in the form of N parallel data bits 13a at a designated sample rate Fₛ. In one example, the ADC 12a is an 8-bit ADC operating at a sample rate of 5 Giga-Samples/second (GSa/s), and the output 20a provides 8 parallel data bits 13a at a total data rate of 40Gb/s.

The I/O interface 10a includes a serializer 22a that transforms the N parallel data bitsl3a, provided by the ADC 12a, into multiple serial data signals 15a. The serializer 22a typically includes a multiplexer or other suitable switching device or system that time-domain multiplexes the N parallel data bits 13a into the multiple serial data signals 15a that each provide serial data at a data rate F_{d}. In one example, the serializer 22a transforms 8 parallel data bits 13a provided at a total data rate of 40 Gb/s, into four serial data signals 15a each having a data rate of 10Gb/s, indicating that the serializer 22a transforms N parallel data bits 13a into N(Fₛ/F_{d}) multiple serial data signals 15a.

Serial data within each of the multiple serial data signals 15a is timed according to the data rate F_{d}, resulting in an implied or embedded clock for the serial data in each of the multiple serial data signals 15a. Accordingly, the serial data signals 15a do not rely on establishing and maintaining alignment with an external clock signal, and each of the multiple serial data signals 15a can be transmitted or distributed independent of clock signals that are external to the multiple serial data signals 15a.

The serializer 22a is coupled to a plurality of signal paths 24a in the I/O interface 10a. Each of the signal paths 24a accommodates a corresponding one of the serial data signals 15a. To provide noise immunity in the I/O interface 10a, each of the signal paths 24a typically includes a pair of signal conductors and each of the multiple serial data signals 15a is a differential signal that is provided between a corresponding pair of the signal conductors. The signal paths 24a are alternatively implemented using microstrip, stripline, coplanar waveguide, or other suitable transmission structures or media.

The I/O interface 10a also includes a de-serializer 26a that is coupled to the signal paths 24a and receives the multiple serial data signals 15a that are provided by the serializer 22a. The de-serializer 26a extracts a clock from each of the multiple serial data signals 15a that is based on the embedded clock within each of the multiple serial data signals 15a. Using the extracted clocks, the de-serializer 26a constructs a data set 17a from the multiple serial data signals 15a. This data set 17a, provided at an output of the de-serializer 26a, represents the samples of the applied analog signal 11a and is typically constructed by re-clocking and demultiplexing the multiple serial data signals 15a received by the de-serializer 26a into a parallel data bus 28a. The parallel data bus 28a is sufficiently wide to enable coupling between the de-seriaizer 26a and a memory, digital signal processor, or other system 14a. In one example, where the de-serializer 26a demultiplexes four serial data signals 15a each at a serial data rate of 10Gb/s, the parallel data bus 28a has 80 parallel data bits, which is wide enough to establish a data rate of 500MHz, and which is sufficiently low to be accommodated by a memory 14a.

The de-serializer 26a typically includes a clock recovery unit or other device or system that is suitable for extracting the embedded clock within each of the multiple serial data signals 15a. In one example, the clock recovery unit includes a clock and data recovery unit, as described in Challenges in the Design of High-speed Clock and Data Recovery Circuits, by Razavi, B., IEEE Communications Magazine, Volume 40, Issue 8, Aug. 2002, pages 94-101.

In some embodiments of the present invention, an encoder 30a is interposed between the ADC 12a and the serializer 22a. The encoder 30a encodes the serial data in each of the multiple serial data signals 15a to provide DC balance within each of the multiple serial data signals 15a. DC balance enables each of the multiple serial data signals 15a to be AC-coupled to the signal paths and AC-coupled to the de-serializer 26a, which can simplify the biasing schemes for drivers and receivers (not shown) that are typically associated with digital data buses and included in the I/O interface 10a. In one example, the encoder 30a provides DC balance with 8B/10B encoding as taught by Widmar, A. X. and P. A. Franaszek, A DC Balanced, partitioned-Block 8B/10B Transmission Code, IBM Journal of Research and Development 27, 5 (September 1983), pages 440-451

In some embodiments of the present invention, the encoder 30a includes a data scrambler that de-correlates noise generated by the ADC 12a from the applied analog signal 11a to reduce distortion of the ADC 12a attributable to signal leakage, for example, between the signal paths 24a and the applied analog signal 11a at the input of the ADC 12a. In one example, the data scrambler includes a self-synchronized scrambler as disclosed by E.A. Lee, et al., Digital Communications, Klewer Academic Publishers, 1988, pages 439-445.

In some embodiments of the present invention, the encoder 30a provides sufficient run-length control for the serial data provided in the multiple serial data lines 15a to enable the de-serializer 26a to extract or recover the clock from each of the multiple serial data lines 15a.

Embodiments of the I/O interface 10a that include the encoder 30a also include a corresponding decoder 32a coupled to the de-serializer 26a.

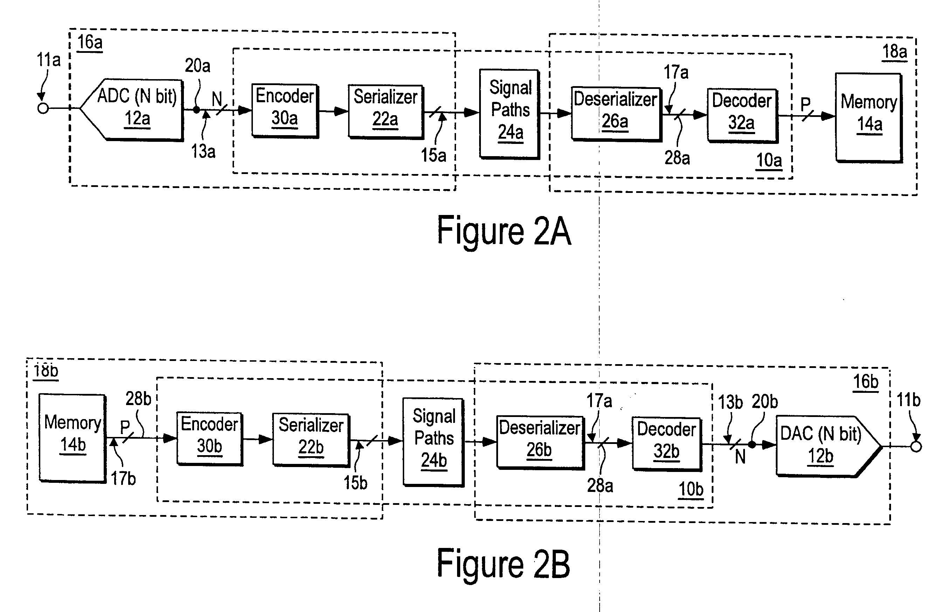

Figure 2B shows an embodiment of the I/O interface 10b that provides coupling between a memory (shown), digital signal processor, or other system 14b, and a digital-to-analog converter (DAC) 12b. In Figure 2B, the I/O interface 10b is shown distributed between a memory system 18b and a DAC integrated circuit 16b, and the DAC 12b is shown as a high-speed N-bit DAC that converts a data set 17b from a memory 14b into a generated analog signal 11b at an output. The data set 17b represents samples that are provided to the DAC 12b to generate the analog signal 11b. The data set 17b is typically provided to a serializer 22b within the I/O interface 10b on a parallel data bus 28b that is sufficiently wide to accommodate the data rate provided by the memory, digital signal processor, or other system 14b.

The serializer 22b typically includes a multiplexer or other suitable switching device or system that time-domain multiplexes P parallel data bits 17b on the parallel data bus 28b to transform the P parallel data bits into multiple serial data signals 15b that each have a data rate F_{d}. In one example, the parallel data bus 28b accommodates 80 parallel data bits and the serializer 22b transforms the 80 parallel data bits at a data rate of 500 Mb/s into four serial data signals 15b that each have a data rate of 10Gb/s.

Serial data within each of the multiple serial data signals 15b is timed according to the data rate F_{d}, resulting in an implied or embedded clock for the serial data in each of the multiple serial data signals 15b. Accordingly, the multiple serial data signals 15b do not rely on establishing and maintaining alignment with an external clock signal, and each of the multiple serial data signals 15b can be transmitted or distributed independent of clock signals that are external to the multiple serial data signals 15b.

The serializer 22b is coupled to a plurality of signal paths 24b included in the I/O interface 10b. Each of the signal paths 24b accommodates a corresponding one of the serial data signals 15b. To provide noise immunity in the I/O interface 10b, each of the signal paths 24b typically includes a pair of signal conductors and each of the multiple serial data signals 15b is a differential signal that is provided between a corresponding pair of the signal conductors. The signal paths 24b are alternatively implemented using microstrip, stripline, coplanar waveguide, or other suitable transmission structures or media.

The I/O interface 10b also includes a de-serializer 26b that is coupled to the plurality of signal paths 24b and receives the multiple serial data signals 15b that are provided by the serializer 22b. The de-serializer 26b extracts a clock from each of the multiple serial data signals 15b that is based on the embedded clock within each of the multiple serial data signals 15b. Using the extracted clocks, the de-serializer 26b constructs parallel data 13b that represents the samples of the generated analog signal 11b. The parallel data 13b is typically constructed by re-clocking and demultiplexing the multiple serial data signals 15b received by the de-serializer 26b into N parallel data bits at a designated sample rate Fₛ at the input 20b of the DAC 12b. In one example, the de-serializer 26b provides 8 parallel data bits 13b each at a data rate of 5 Gb/s to achieve a total data rate of 40Gb/s. The DAC 12b then generates the analog signal 11b based on the parallel data 13b. In this example, the analog signal 11b is generated by the DAC 12b that operates at a conversion rate of 5GSa/s.

The de-serializer 26b typically includes a clock recovery unit or other device or system that is suitable for extracting the embedded clock within each of the multiple serial data signals 15b.

In some embodiments of the I/O interface 10b, an encoder 30b is interposed between the memory 14b and the serializer 22b to provide DC balance within each of the multiple serial data signals 15b. The encoder 30b can also include a data scrambler to de-correlate noise on the parallel data 13b provided to the DAC 12b from the generated analog signal 11b to reduce distortion attributable to signal leakage, for example, between the signal paths 24b and the generated analog signal 11b at the output of the DAC 12b. The encoder 30b can also provide sufficient run-length control for the serial data provided in the multiple serial data lines 15b to enable the de-serializer 26b to extract or recover the clock from each of the multiple serial data lines 15b.

Embodiments of the I/O interface 10b that include the encoder 30b also include a corresponding decoder 32b coupled to the de-serializer 26b.

In some embodiment of the I/O interface 10b shown in Figure 2B, the DAC 12b includes a series of time-interleaved DACs. In this embodiment, parallel data bits 13b provided by the de-serializer 26b are time interleaved to achieve a correspondingly higher bandwidth for the analog signals 11b that are generated by the series of time-interleaved DACs. For example, a series of four time-interleaved DACs each operating at 1.25GSa/s can generate an analog signal 11b based on a resulting sample rate of 5GSa/s.

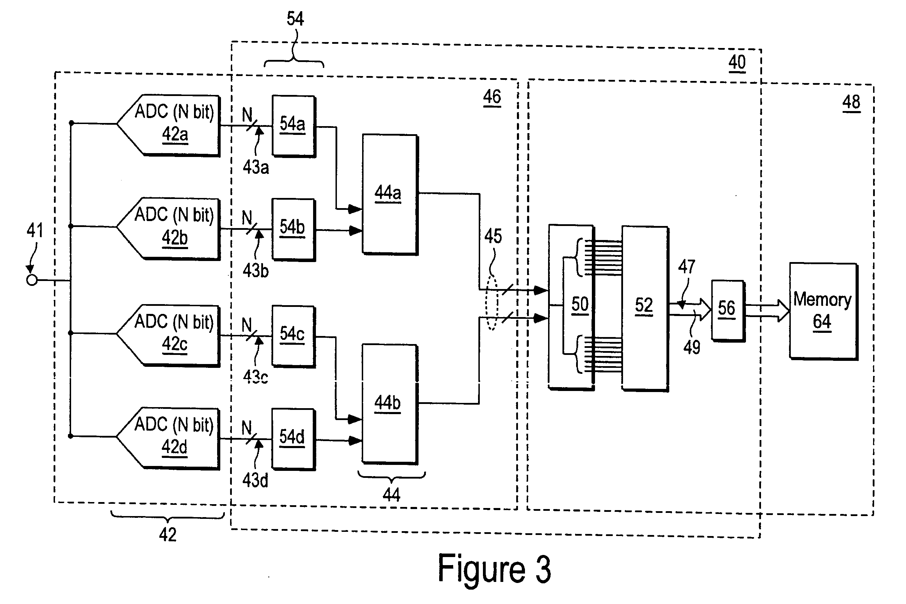

Figure 3 shows an I/O interface 40 according to some embodiments of the present invention. Typically, the I/O interface 40 provides coupling between a series of M data converters, such as a series of ADCs 42, and a memory, data processor, or other system 44. In the example shown in Figure 3, the I/O interface 40 is distributed between an ADC integrated circuit 46 and a memory system 48. For the purpose of illustration, the series of M ADCs 42 is shown including a series of four high-speed N-bit ADCs 42a-42d that converts an applied analog signal 41 into time-interleaved samples of the analog signal 41 at a total sample rate Fₛₘ. Time interleaving the samples of the analog signal 41 using the series of four ADCs 42a-42d enables the total sample rate Fₛₘ to be four times the sample rate Fₛ of each of the individual ADCs 42a-42d in the series of M ADCs 42.

Samples of the applied analog signal 41 are typically provided at the outputs of the series of M ADCs 42 in the form of M groups of N parallel data bits (indicated in this example by reference designators 43a-43d), wherein each of the M groups of N parallel data bits 43a-43d is provided at a data rate that is equal to the sample rate Fₛ. In one example wherein M=4, N=8, and the sample rate Fₛₘ = 5GSa/s, the series of M ADCs 42 provides four groups of 8 parallel data bits 43a-43d at a data rate of 1.25Gb/s, so that each of the groups of N parallel data bits 43a-43d has a total data rate of 10Gb/s.

The I/O interface 40 includes a set of K serializers 44 that receives the M groups of N parallel data bits 43a-43d from the series of M ADCs 42, and transforms the M groups of N parallel data bits 43a-43d into multiple serial data signals 45. In the example shown in Figure 3, wherein K=2, M=4, N=8, and Fₛₘ= 5GSa/s, two serializers 44a, 44b are shown each receiving two groups of 8 parallel data bits 43a-43d, indicating that each of the serializers 44a, 44b receives groups of N parallel data bits from more than one of the ADCs 42a-42d in the series of ADCs 42. In this example, each of the serializers 44a, 44b in the set of serializers 44 receives 16 parallel data bits at a data rate of 1.25Gb/s and the set of serializers 44 transforms 32 parallel data bits into four serial data signals 45 each providing serial data at a data rate of 10Gb/s.

The set of K serializers 44 is coupled to a plurality of signal paths 50. Each of the signal paths 50 accommodates a corresponding one of the serial data signals 45. To provide noise immunity for the I/O interface 40, each signal path typically includes a pair of signal conductors and each of the multiple serial data signals is a differential signal that is provided between a corresponding pair of the signal conductors. The signal paths 50 are alternatively implemented using microstrip, stripline, coplanar waveguide, or other suitable transmission structures or media.

A de-serializer 52 coupled to the plurality of signal paths 50 receives the serial data signals 45 provided by the set of serializers 44. The de-serializer 52 extracts a clock from each of the multiple serial data signals 45 that is based on the embedded clock within each of the multiple serial data signals 45. Using the extracted clocks, the de-serializer 52 constructs a data set 47 from the multiple serial data signals 45. This data set 47, provided at an output of the de-serializer 52, represents the acquired samples of the applied analog signal 41, and is typically constructed by re-clocking the received multiple serial data signals 45 into a memory, digital signal processor, or other system 64 that is coupled to the de-serializer 52. In one example, the data set 47 is provided to a memory 64 on a parallel data bus 49 that is sufficiently wide to enable coupling between the de-serializer 52 and the memory 64.

The de-serializer 52 typically includes a clock recovery unit or other suitable circuit, device or system to extract the embedded clock from each of the multiple serial data signals 45.

In an embodiment of the I/O interface 40 a series of encoders 54 is interposed between each ADC in the series of ADCs 42 and each serializer in the set of serializers 44 to provide DC balance within each of the multiple serial data signals 45. In another embodiment of the I/O interface 40, the encoders in the series of encoders 54 include data scramblers that de-correlate noise generated by the ADCs 42a-42d from the applied analog signal 41 to reduce distortion of the ADCs that is attributable to signal leakage, for example, between the signal paths 50 and the analog signal 41 at the input to the series of ADCs 42. In an
embodiment of the I/O interface 40, the encoders in the series of encoders 54 provide sufficient run-length control for the serial data provided in the multiple serial data signals 45 to enable the de-serializer 52 to extract or recover the clock from each of the multiple serial data lines 45.

Embodiments of the I/O interface 40 that include the series of encoders 54 also include a corresponding decoder 56 coupled to the de-serializer 52.

When included in the embodiments of the present invention, the encoders and decoders typically add overhead to the serial data within each of the multiple serial data signals 15a, typically in the form of additional serial data bits. Since the added overhead typically depends on the type of encoders and decoders, the additional serial data bits have not been included in the data rates of the provided examples.

The disclosures in United States patent application No. 11/173,134, from which this application claims priority, and in the abstract accompanying this application are incorporated herein by reference.

## Claims

1. A system, including:
a serial izer (22a) for transforming parallel data bits from an ADC (12a) into multiple serial data signals each having a corresponding embedded clock, the parallel data bits representing samples of an applied signal (11a) acquired by the ADC (12a);
a plurality of signal paths (24a) each operable to accommodate a corresponding one of the multiple serial data signals (15a); and
a de-serializer (26a) for extracting a clock from each of the multiple serial data signals (15a) and for constructing a data set (17a) based on serial data within each of the multiple serial data signals (15a), wherein the data set (17a) represents the samples of the applied signal (11a).

2. A system according to claim 1, wherein the de-serializer (16a) is operable to provide the data set (17a) on a parallel data bus (28a) that provides parallel data bits wherein each of the parallel data bits has a date rate that is lower than the data rate of serial data (17a) within each of the multiple serial data signals.

3. A system including:
a serializer (22b) for transforming a first set of parallel data bits (17b) that represent samples of an output signal into multiple serial data signals (15b) that each have a corresponding embedded clock;
a plurality of signal paths (24b) that each accommodate a corresponding one of the multiple serial data signals (15b); and
a de-serializer (26b) for extracting a clock from each of the multiple serial data signals (15b) and for providing a second set of parallel data bits (13b) to a digital-to-analog converter (DAC) (12b), wherein the DAC (12b) is operable to provide the output signal (11b) in response to receiving the second set of parallel data bits (13b).

4. A system according to claim 1, 2 or 3, wherein:
a) the ADC (13a) includes an N-bit ADC and the number of multiple serial data signals (15a) is equal to N times the ratio of the sample rate to the data rate of the serial data within each of the multiple serial data signals; or
b) the DAC (12b) includes a N-bit DAC and the number of multiple serial data signals (15b) is equal to N times the ratio of a data conversion rate of the DAC (12b) to the data rate of the serial data within each of the multiple serial data signals (15b).

5. A system according to any preceding claim, wherein the ADC (12a) includes two or more analog-to-digital converters for acquiring time-interleaved samples of the applied signal or wherein the DAC (12b) includes two or more DACs operable to receive time-interleaved parallel data bits that represent the output signal (11b).

6. A system according to any preceding claim, including an encoder (30a, 30b) interposed between the ADC (12a) or the DAC (12b) and the serializer (22a, 22b), wherein the encoder (30a, 30b) is operable to provide at least one of a DC balance within each of the multiple data signals, a de-correlation of noise of the ADC (12a) from the applied signal or of the DAC (12b) from the output signal, and run-length control for the serial data within each of the multiple serial data signals.

7. A system according to claim 1, including:
a set of serializers (44) coupled to a series of analog-to-digital (ADC) converters (42) operable to acquire time-interleaved samples of an applied signal (41) at a sample rate, the set of serializers (44) being operable to receive parallel data bits from the series of ADCs (42) and to transform the received parallel data bits into multiple serial data signals each having a corresponding embedded clock;
wherein the data set represents the time-interleaved samples of the applied signal.

8. A system according to claim 7, wherein each of the serializers (44a, 44b) in the set of serializers is operable to provide one serial data signal.

9. A system according to claim 8, wherein each of the serializers (44a, 44b) in the set of serializers (44) is operable to receive parallel data bits from more than one ADC (42a-42d) in the series of ADCs (42).

10. A system according to claim 7, 8 or 9, wherein each of the ADCs (42a-42d) in the series of ADCs (42) is operable to acquire the time-interleaved samples (41) at the sample rate divided by the number of ADCs (42a-42d) in the series of ADCs (42).

11. A system according to any one of claims 7 to 10, including a series of encoders (54) interposed between the series of ADCs (42) and the set of the serializers (44), wherein the series of encoders (54) is operable to provide at least one of a DC balance within each of the multiple data signals, a de-correlation of noise of the ADCs (42a-42d) in the series of ADCs from the applied signal, and run-length control for the serial data within each of the multiple serial data signals.

12. A system according to any preceding claim, wherein each signal path in the plurality of signal paths includes a pair of conductors and wherein each of the multiple serial data signals is a differential signal.

13. A system according to any preceding claim, wherein the de-serializer (26a, 26b, 52) includes a clock recovery unit operable to extract the clock for each of the multiple serial data signals based on the corresponding embedded clock of each of the multiple serial data signals.
